# DEMANDE DE BREVET EUROPEEN

(11) **EP 1 253 815 A1**
(43) Date de publication de la demande: **30.10.2002**
(21) Numéro de dépôt: 01440121.0
(22) Date de dépôt: 23.04.2001
(51) Int. Cl.: H05K 9/00

(54) **Dispositif pour la protection contre le rayonnement non ionisant et construction comportant un tel dispositif**

(71) Demandeur: Zerr, Françoise, 68720 Tagolsheim (FR)
(72) Inventeur: Zerr, Françoise, 68720 Tagolsheim (FR)
(74) Mandataire: Nuss, Pierre

(57) **Abrégé**

La présente invention a pour objet un dispositif pour la protection contre le rayonnement non ionisant et une construction comportant un tel dispositif.

Dispositif caractérisé en ce qu'il consiste en une cage de Faraday ou une partie de cage de Faraday recouvrant au moins partiellement une ou plusieurs des parois ou murs (2) du local à protéger et formée par un assemblage jointif de pièces (3) en forme de plaques ou de panneaux, fixées à la ou auxdites parois (2) et portant chacune un motif grillagé (4) formé par un matériau conducteur à base de graphite et connecté électriquement avec au moins un motif grillagé (4) d'au moins une autre pièce (3) en forme de plaque ou de panneau, de manière à constituer une structure grillagée conductrice interconnectée formant ladite cage de Faraday ou partie de cage de Faraday.

## Description

La présente invention concerne de manière générale le domaine de la santé des personnes, notamment la prévention des risques induits par l'exposition des personnes aux charges électriques et électromagnétiques, et a pour objet un dispositif pour la protection contre le rayonnement non ionisant produit par les champs électriques et/ou électromagnétiques.

Actuellement, les pièces d'habitation et à usage professionnel comportent souvent un grand nombre d'appareils électriques et électroniques et leurs murs sont parcourus par un grand nombre de conducteurs électriques.

Or, ces appareils induisent tous, directement ou indirectement, même lorsqu'ils ne sont pas en fonctionnement ou utilisés, des champs électriques et électromagnétiques. De même, tout élément de mobilier ou d'équipement, comme par exemple un lit, une chaise, une table d'ordinateur etc., est porteur de charges électriques aptes à induire des champs électromagnétiques.

Différentes études sur la question des répercussions de ces ondes en termes d'impact sur la santé ont été publiées.

Ainsi, dans "Electrical wiring configurations and Childhood cancer", mars 1979, Nancy Wertheimer, l'auteur s'applique à examiner les facteurs d'environnement susceptibles de favoriser le développement de la leucémie chez l'enfant. Elle a constaté qu'un pourcentage anormalement élevé de sujets atteints (l'étude portait sur 344 cas) habitait dans des maisons situées à proximité d'un gros transformateur perché au sommet d'un poteau électrique.

Dans un rapport établi pour "New-York Health/ Power Lines Project" en août 1981, Perry, Reichmanis, Marino et Becker mettent en évidence une corrélation significative entre le taux de suicides et l'exposition à un champ magnétique supérieur à un microtesla.

Dans l'article "Cross Currents", Los Angeles, Jeremy P. Tarcher Inc., 1990, le Dr. Robert Becker établissait de son côté une corrélation entre des taux élevés de mortalité infantile chez les sujets exposés dans leur environnement immédiat à des champs électromagnétiques de 60 Hertz (Hz), fréquence de la plupart des installations électriques domestiques américaines. Ce même chercheur a également constaté que les taux de triglycérides dans le sérum sanguin augmentent sous l'influence d'une réaction de stress électromagnétique.

Depuis, d'innombrables recherches sont venues confirmer qu'une exposition répétée à des champs électromagnétiques peut avoir des répercussions sur la santé publique (voir notamment : GRUNDLER W., KAISER F., KEILMANN F. and WALLECZEK J., Naturwissenschaft 79 (1992) 551-559 ; Von KLITZING L., Brain Res. 549 (1991) 295-296 ; WALLECZEK J., FASEB J. 6 (1992) 3177-3185 ; SANTINI R., " Notre santé face aux champs électriques et magnétiques. Des faits scientifiques aux conseils pratiques", Ed. Sully (1995) 157 pages).

En outre, le 5 mai 1994, le Parlement Européen votait une motion en faveur d'une résolution invitant les Etats membres à "conjuguer leurs efforts pour mettre en oeuvre un programme de standardisation et de recherche multidisciplinaire destiné à protéger la population contre les effets dommageables des rayonnements non ionisants."

En effet, une exposition fréquente aux champs électromagnétiques peut affecter de diverses manières la santé des personnes, et notamment la qualité du sommeil, soit par insomnie, soit sous forme de sommeil non réparateur. Divers travaux ont mis en évidence qu'une exposition régulière et répétée aux champs électriques ou électromagnétiques peut réduire chez certains sujets la capacité du système immunitaire à combattre certains agents pathologiques, et de ce fait déclencher indirectement des problèmes de santé beaucoup plus graves, notamment un cancer, la mort subite du nourrisson, des fausses-couches, des dépressions voire des suicides.

Par ailleurs, il a été relevé que le cerveau, qui émet des ondes électromagnétiques à basse fréquence, est manifestement sensible à des rayonnements de fréquence proche du réseau, soit 50 Hz. L'exposition prolongée à des champs même faibles de l'ordre de quelques microteslas pour les champs magnétiques et de quelques dizaines de volts par mètre pour les champs électriques, perturbe le système nerveux et joue un rôle de promotion du cancer.

Il convient de noter toutefois que, finalement, ce n'est pas le champ électrique ou magnétique lui-même, ni la tension ou le courant électrique d'une manière générale, qui sont néfastes, mais le courant que ceux-ci créent à travers l'organisme.

En laboratoire, il a été constaté que pour un courant alternatif de cinquante périodes, le déplacement ionique commençait dans le corps humain à partir de cinquante microampères. Au-dessus du milliampère, le phénomène se réduit encore à une simple impression de fourmillement. Avec des intensités de quelques milliampères, apparaissent des tremblements et des contractures musculaires, et au-dessus de 6 à 10 milliampères, la contracture est suffisante pour empêcher le sujet de se libérer spontanément. Ces expériences réalisées en laboratoire provoquent des effets directs et instantanés.

Même s'il est vrai que, dans la vie quotidienne, les courants sont plus faibles, il n'en est pas moins vrai que l'exposition à long terme à des faibles valeurs provoque des effets plus lents, pervers, cumulatifs et différents selon les prédispositions de chaque individu.

Pour tenter de protéger les individus contre ces effets néfastes, il a été proposé de revêtir les murs des habitations d'une couche de peinture conductrice susceptible de faire obstacle aux rayonnements précités et d'isoler le volume intérieur de la pièce ou une partie de ce denier par rapport auxdits rayonnements.

Toutefois, l'application de ce type de peinture est, du fait de sa nature et de sa texture, très fastidieuse, revient relativement cher du fait du prix de ces peintures et produit une surface difficile à recouvrir et à cacher, en fournissant notamment une couche d'accrochage de très mauvaise qualité.

La présente invention a notamment pour but de pallier les inconvénients de la solution existante indiquée ci-dessus.

A cet effet, elle a pour objet un dispositif pour la protection contre le rayonnement non ionisant produit par les champs électriques et/ou électromagnétiques, dans un local ou un espace d'habitation tel qu'une pièce, une chambre, un bureau ou analogue, caractérisé en ce qu'il consiste en une cage de Faraday ou une partie de cage de Faraday recouvrant au moins partiellement une ou plusieurs des parois ou murs du local à protéger et formée par un assemblage jointif de pièces en forme de plaques ou de panneaux, fixées à la ou auxdites parois et portant chacune un motif grillagé formé par un matériau conducteur à base de graphite et connecté électriquement avec au moins un motif grillagé d'au moins une autre pièce en forme de plaque ou de panneau, de manière à constituer une structure grillagée conductrice interconnectée formant ladite cage de Faraday ou partie de cage de Faraday.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
La figure 1 est une vue frontale schématique d'une partie d'un dispositif installé sur un mur d'une pièce,
la figure 2 est une vue de face d'une pièce en forme de plaque ou de panneau formant un module du dispositif représenté à la figure 1, et,
la figure 3 est une vue en élévation latérale selon la direction D de la pièce représentée sur la figure 2.

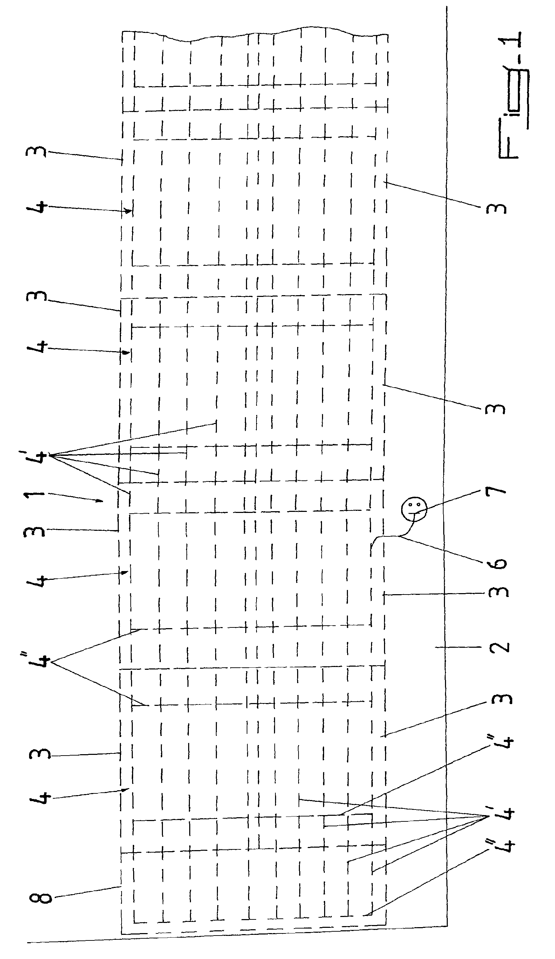

La figure 1 des dessins annexés représente, appliquée sur un mur 2 d'une pièce, un dispositif 1 pour la protection contre le rayonnement non ionisant produit par les champs électriques et/ou électromagnétiques.

Le dispositif 1 est principalement caractérisé en ce qu'il consiste en une cage de Faraday ou une partie de cage de Faraday recouvrant au moins partiellement une ou plusieurs des parois ou murs 2 du local à protéger et formée par un assemblage jointif de pièces 3 en forme de plaques ou de panneaux, fixées à la ou auxdites parois 2 et portant chacune un motif grillagé 4 formé par un matériau conducteur à base de graphite et connecté électriquement avec au moins un motif grillagé 4 d'au moins une autre pièce 3 en forme de plaque ou de panneau, de manière à constituer une structure grillagée conductrice interconnectée formant ladite cage de Faraday ou partie de cage de Faraday.

Le matériau formant le motif grillagé 4 pourra être rapporté sur les pièces 3 de différentes manières, par exemple par application superficielle, imprégnation, injection dans la masse, dépôt dans des rainures préalablement tracées ou analogue, en fonction des natures des matériaux des pièces 3 et du motif grillagé 4.

Conformément à un mode de réalisation préféré de l'invention, représenté aux figues 2 et 3 des dessins annexés, chaque pièce 3 en forme de plaque ou de panneau, formant un module constitutif dudit dispositif de protection 1, est composée de deux parties 3' et 3" en forme de plaques contrecollées, l'une 3' portant un motif grillagé 4 présentant un pas de maillage sensiblement identique pour toutes les pièces 2 et dessiné au moyen d'une peinture à base de graphite et l'autre 3" étant rapportée par collage et pressage sur la face de la partie en forme de plaque 3' pourvue dudit motif grillagé 4, ce dernier étant ainsi pris en sandwich entre les deux parties en forme de plaques 3' et 3" et le contrecollage étant préférentiellement réalisé au moyen d'une colle biologique sans solvant.

Grâce à ces dispositions, la peinture à base de graphite difficile à couvrir, de nature grasse et facilement endommageable, est emprisonnée entre deux supports matériels qui l'isolent de l'extérieur, évitent que ses propriétés désavantageuses n'affectent les travaux de finition et permettent une installation et une application aisées par l'utilisateur en fournissant un support d'accrochage idéal pour une couche de finition.

En outre, les quantités de peinture nécessaires sont très limitées par rapport à une application pleine surface, tout en garantissant une efficacité au moins égale en terme de piégeage et de capture des champs électriques de basses fréquences, ainsi que des champs électromagnétiques et des champs électrostatiques.

De plus, la régularité et la précision de la structure grillagée obtenue permettent de garantir une efficacité uniforme du dispositif de protection 1 sur toute son étendue.

Enfin, les pièces 3 pourront être préfabriquées en usine, soit aisément transportables et manipulables et peuvent être appliquées comme tout matériau en forme de plaque habituellement utilisé dans les travaux intérieurs.

La peinture à base de graphite utilisée pourra par exemple être du type de celle commercialisée par la société ARCHIBO RESEARCH (Belgique).

De manière avantageuse, les parties 3', 3" en forme de plaques, carrées en rectangulaires, consistent en un matériau choisi dans le groupe formé par le carton, le plâtre, le liège, les polymères expansés et le bois, ainsi que par les agglomérés ou les composites ou laminés à base des matériaux précités, les deux parties 3' et 3" d'une même pièce 3 pouvant être composées du même matériau ou de deux matériaux différents.

Selon une première variante de réalisation préférée de l'invention, les deux parties 3' et 3" des pièces 3 en forme de plaques ou de panneaux consistent en des plaques cartonnées (par exemple deux plaques de carton de 0,7 mm d'épaisseur).

Selon une seconde variante de réalisation préférée de l'invention, l'une 3' des parties des pièces 3 en forme de plaques ou de panneaux consiste en une plaque de liège et l'autre partie 3" consiste en une plaque de carton (par exemple une plaque de liège de 10 mm d'épaisseur et une plaque de carton de 0,7 mm d'épaisseur).

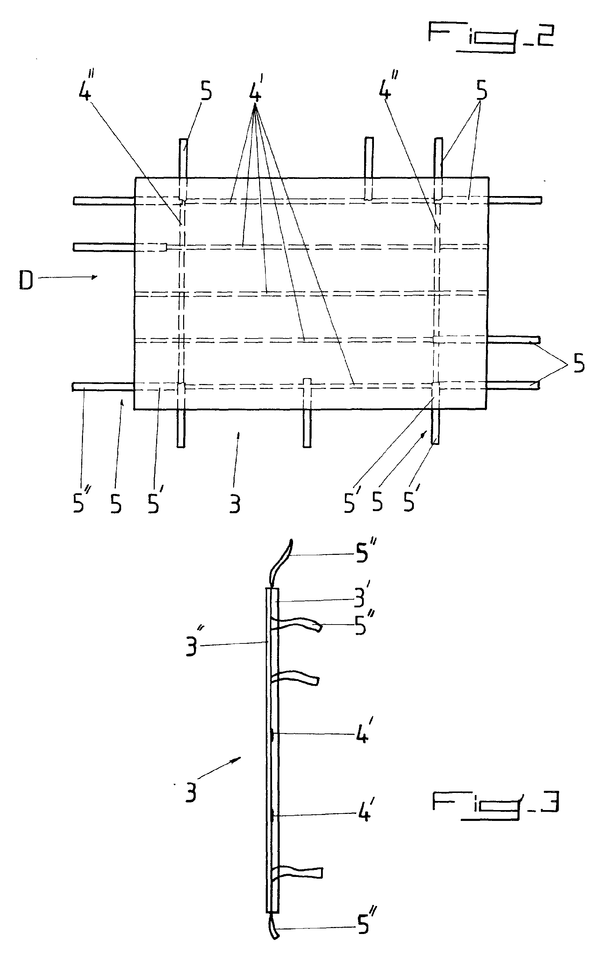

Comme le montrent les figures 1 et 2 des dessins annexés, le motif grillagé 4 de chaque pièce 3 en forme de plaque ou de panneau est formé de premiers segments de droites 4' espacés et parallèles entre eux, s'étendant selon la direction horizontale d'installation de ladite pièce 3 et reliés entre eux par au moins deux seconds segments de droite 4" s'étendant dans une direction sensiblement perpendiculaire à celle des premiers segments de droite 4' ledit motif grillagé 4 couvrant la majorité de la surface de la pièce 3 correspondante, à l'exception, le cas échéant, de certaines zones de bord de celle-ci.

A titre d'exemple, permettant d'aboutir à un bon rapport efficacité/prix de revient, les premiers segments de droite 4' peuvent être écartés de 5 à 15 cm, préférentiellement d'environ 10 cm, et les seconds segments de droite 4" être espacés d'environ 50 à 80 cm, préférentiellement d'environ 65 cm, le tracé des motifs grillagés 4 pouvant présenter une largeur comprise entre 2 et 5 cm, préférentiellement d'environ 3 cm.

En variante au motif de maillage rectangulaire décrit ci-dessus et représenté aux dessins annexés, il peut aussi être prévu un motif à mailles de forme carrée, hexagonale ou octogonale pour le motif grillagé 4, les lignes ou segments de droites 4' et 4" externes situés près des bords des pièces 3 étant conservés.

Conformément à une caractéristique de l'invention, représentée sur les figures 1 et 2, la connexion ou liaison électrique entre les motifs grillagés 4 de deux pièces 3 en forme de plaques ou de panneaux adjacentes est réalisée au moyen de bandelettes 5 en papier cuivré sur une face ou en tissu intégrant des fils métalliques, dont une première portion 5' est reliée électriquement au motif grillagé 4 desdites pièces 3 et solidarisés entre les parties 3' et 3" en forme de plaques et dont une seconde portion 5" libre, s'étend au-delà du bord de la pièce 3 en forme de plaque ou de panneau et est destinée à être reliée à une bandelette 5 d'une pièce 3 adjacente ou au motif grillagé 4 de cette dernière, lesdites bandelettes 5 étant réparties sur les différents côtés desdites pièces 3 en forme de plaques ou de panneaux.

En vue d'évacuer les chargés induites par les champs captés par le dispositif de protection 1, ce dernier comprend préférentiellement au moins une pièce 3 en forme de plaque ou de panneau pourvue d'un fil ou câble de connexion 6 destiné à être relié à une borne de terre 7 d'une prise électrique (cette dernière pouvant éventuellement déboucher dans une pièce 3 au niveau d'une ouverture découpée correspondante).

Par ailleurs, pour pouvoir assurer également un bouclage de la structure grillagée formée par l'interconnexion des motifs grillagés modulaires 4 des différentes pièces 3 lorsqu'il est nécessaire de découper une pièce 3 pour des raisons dimensionnelles, ledit dispositif de protection 1 peut comprendre, en outre, au moins une pièce 8 en forme de plaque ou de panneau de plus faible largeur, pourvue d'un unique second segment de droite 4" relié à des portions de premiers segments de droite 4' s'étendant d'un côté uniquement dudit second segment de droite 4" et prolongées par des bandelettes de connexion 5.

Différentes mesures ont été effectuées par les inventeurs pour tester l'efficacité d'une pièce 3 en forme de plaque ou de panneau selon l'invention, formée de deux plaques de carton de 0,7 mm d'épaisseur contrecollée et emprisonnant un motif grillagé 4 présentant un maillage dont les dimensions correspondent aux indications préférentielles mentionnées précédemment.

Ces mesures ont été réalisées en relevant la différence de potentiel de charge électrique induite à 30 cm par l'élément générateur (lampe, fils électriques), avec et sans interposition d'une ou de deux pièce(s) 3 du type présentée sur la figure 2 présentant des dimensions de 60 cm sur 90 cm.

Deux types de mesures différentes ont été réalisés, à savoir, d'une part, une mesure capacitive entre une prise de terre et une sonde pendue dans le vide et branchée sur un voltmètre et, d'autre part, une mesure capacitive entre une prise de terre et une sonde tenue dans la main par une personne et branchée sur un voltmètre.

### Exemple 1 :

Dans cet exemple, le mesurage a été effectué pour une lampe posée sur un bureau dont le fil d'alimentation montant a été séparé du lieu de mesure par une seule pièce 3. La distance entre le fil et la sonde de mesure était de 30 cm.

Dans le cas 1a, la différence de potentiel initiale dans le vide était de 0,198 volt, après interposition d'une pièce 3 la différence n'était plus que de 0,015 volt, soit une amélioration de 92 %.

Dans le cas 1b le corps humain faisant fonction d'antenne, a été séparé du lieu de mesure par une pièce 3. La distance entre le fil et la personne mesurée était de 30 cm. La différence de potentiel initiale était de 3,426 volts. Après interposition d'une pièce 3, cette différence était seulement 0,725 volt, donc une amélioration de 78 %.

| | **Sans pièce 3** | **Avec pièce 3** | **Ecart** | **Rendement en %** |
|---|---|---|---|---|
| 1a ― Différence de potentiel dans le vide | 0,198 | 0,015 | 0,183 | 92,42 |
| 1b ― Différence de potentiel sur humain | 3,426 | 0,725 | 2,701 | 78,84 |

### Exemple 2 :

Dans cet exemple, le mesurage a été effectué sur une partie de mur d'une chambre à coucher contenant une ligne montante de 220 volts sous tension. Une pièce 3 ou deux pièces 3 superposées verticalement sont appliquées sur le mur. La distance entre la ligne montante et la sonde était de 30 cm.

Dans le cas 2a la différence de potentiel initiale dans le vide était de 0,55 volt, après application d'une pièce 3 la différence n'était plus que de 0,054 volt, soit une amélioration de 90 %.

Dans le cas 2b, le corps humain, faisant fonction d'antenne, a été séparé de la ligne montante par deux plaques cartonnées superposées appliquées sur le mur. La distance entre la ligne montante et la personne mesurée était de 30 cm. La différence de potentiel initiale était de 0,502 volt. Après application des deux pièces 3, celle-ci n'était plus que de 0,175 volt, donc une amélioration de 65 %.

Il est à noter que les deux pièces ainsi posées ne couvraient que les 2/3 de la ligne montante. Ainsi il est possible de conclure qu'une performance plus grande que 65 % peut être attendue si la totalité de la ligne montante est couverte.

| | **Sans pièce 3** | **Avec pièce 3** | **Ecart** | **Rendement en %** |
|---|---|---|---|---|
| 2a ― Différence de potentiel dans le vide | 0,55 | 0,054 | 0,546 | 90,18 |
| 2b ― Différence de potentiel sur humain | 0,502 | 0,175 | 0,327 | 65,14 |

La présente invention a également pour objet une construction du type immeuble ou maison d'habitation, comprenant une ou plusieurs pièces, caractérisée en ce qu'au moins une partie d'au moins un mur 2 d'au moins une pièce de cette construction est pourvue d'un dispositif de protection 1 tel que décrit ci-dessus.

Les pièces 3 en forme de plaque ou de panneau sont préférentiellement fixées au moyen d'une colle contact sur tout type de support formant les murs, le plafond ou le sol de la pièce considérée, uniquement à l'intérieur et dans des endroits secs.

Bien entendu, l'invention n'est pas limitée aux modes de réalisation décrits et représentés aux dessins annexés. Des modifications restent possibles, notamment du point de vue de la constitution des divers éléments ou par substitution d'équivalents techniques, sans sortir pour autant du domaine de protection de l'invention.

## Revendications

1. Dispositif pour la protection contre le rayonnement non ionisant produit par les champs électriques et/ou électromagnétiques, dans un local ou un espace d'habitation tel qu'une pièce, une chambre, un bureau ou analogue, **caractérisé en ce qu'**il consiste en une cage de Faraday ou une partie de cage de Faraday recouvrant au moins partiellement une ou plusieurs des parois ou murs (2) du local à protéger et formée par un assemblage jointif de pièces (3) en forme de plaques ou de panneaux, fixées à la ou auxdites parois (2) et portant chacune un motif grillagé (4) formé par un matériau conducteur à base de graphite et connecté électriquement avec au moins un motif grillagé (4) d'au moins une autre pièce (3) en forme de plaque ou de panneau, de manière à constituer une structure grillagée conductrice interconnectée formant ladite cage de Faraday ou partie de cage de Faraday.

2. Dispositif selon la revendication 1, **caractérisé en ce que** chaque pièce (3) en forme de plaque ou de panneau, formant un module constitutif dudit dispositif de protection (1), est composée de deux parties (3' et 3") en forme de plaques contrecollées, l'une (3') portant un motif grillagé (4) présentant un pas de maillage sensiblement identique pour toutes les pièces (2) et dessiné au moyen d'une peinture à base de graphite et l'autre (3") étant rapportée par collage et pressage sur la face de la partie en forme de plaque (3') pourvue dudit motif grillagé (4), ce dernier étant ainsi pris en sandwich entre les deux parties en forme de plaques (3' et 3") et le contrecollage étant préférentiellement réalisé au moyen d'une colle biologique sans solvant.

3. Dispositif selon la revendication 2, **caractérisé en ce que** les parties (3', 3") en forme de plaques, carrées en rectangulaires, consistent en un matériau choisi dans le groupe formé par le carton, le plâtre, le liège, les polymères expansés et le bois, ainsi que par les agglomérés à base des matériaux précités, les deux parties (3' et 3") d'une même pièce (3) pouvant être composées du même matériau ou de deux matériaux différents.

4. Dispositif selon l'une quelconque des revendications 2 et 3, **caractérisé en ce que** les deux parties (3' et 3") des pièces (3) en forme de plaques ou de panneaux consistent en des plaques cartonnées.

5. Dispositif selon l'une quelconque des revendications 2 à 4, **caractérisé en ce que** l'une (3') des parties des pièces (3) en forme de plaques ou de panneaux consiste en une plaque de liège et l'autre partie (3 ") consiste en une plaque de carton.

6. Dispositif selon l'une quelconque des revendications 1 à 5, **caractérisé en ce que** le motif grillagé (4) de chaque pièce (3) en forme de plaque ou de panneau est formé de premiers segments de droites (4') espacés et parallèles entre eux, s'étendant selon la direction horizontale d'installation de ladite pièce (3) et reliés entre eux par au moins deux seconds segments de droite (4") s'étendant dans une direction sensiblement perpendiculaire à celle des premiers segments de droite (4') ledit motif grillagé (4) couvrant la majorité de la surface de la pièce (3) correspondante, à l'exception, le cas échéant, de certaines zones de bord de celle-ci.

7. Dispositif selon l'une quelconque des revendications 2 à 6, **caractérisé en ce que** la connexion entre les motifs grillagés (4) de deux pièces (3) en forme de plaques ou de panneaux adjacentes est réalisée au moyen de bandelettes (5) en papier cuivré sur une face ou en tissu intégrant des fils métalliques, dont une première portion (5') est reliée électriquement au motif grillagé (4) desdites pièces (3) et solidarisés entre les parties (3' et 3") en forme de plaques et dont une seconde portion (5") libre, s'étend au-delà du bord de la pièce (3) en forme de plaque ou de panneau et est destinée à être reliée à une bandelette (5) d'une pièce (3) adjacente ou au motif grillagé (4) de cette dernière, lesdites bandelettes (5) étant réparties sur les différents côtés desdites pièces (3) en forme de plaques ou de panneaux.

8. Dispositif selon l'une quelconque des revendications 2 à 7, **caractérisé en ce qu'**il comprend au moins une pièce (3) en forme de plaque ou de panneau pourvue d'un fil ou câble de connexion (6) destiné à être relié à une borne de terre (7) d'une prise électrique.

9. Dispositif selon les revendications 6 et 7, **caractérisé en ce qu'**il comprend au moins une pièce (8) en forme de plaque ou de panneau de plus faible largeur, pourvue d'un unique second segment de droite (4") relié à des portions de premiers segments de droite (4') s'étendant d'un côté uniquement dudit second segment de droite (4") et prolongées par des bandelettes de connexion (5).

10. Construction du type immeuble ou maison d'habitation, comprenant une ou plusieurs pièces, **caractérisée en ce qu'**au moins une partie d'au moins un mur d'au moins une pièce de cette construction est pourvue d'un dispositif de protection (1) selon l'une quelconque des revendications 1 à 9.
